# FASCICULE DE BREVET EUROPEEN

(11) **EP 2 993 694 B1**
(45) Date de publication et mention de la délivrance du brevet: **28.02.2018**
(21) Numéro de dépôt: 15183186.4
(22) Date de dépôt: 31.08.2015
(51) Int. Cl.: H01L 25/07, H01L 23/498, H01L 23/00, H05K 3/34, H05K 7/02, H05K 7/06, H05K 7/10

(54) **MODULE ÉLECTRONIQUE HAUTE PUISSANCE ET PROCÉDÉ DE FABRICATION D'UN TEL MODULE**
ELEKTRONISCHES HOCHLEISTUNGSMODUL UND HERSTELLUNGSVERFAHREN EINES SOLCHEN MODULS
HIGH-POWER ELECTRONIC MODULE AND METHOD FOR MANUFACTURING SUCH A MODULE

(30) Priorité: 08.09.2014 FR 1458390
(43) Date de publication de la demande: 09.03.2016
(73) Titulaire: Schneider Electric Industries SAS, 92500 Rueil-Malmaison (FR)
(72) Inventeur: WU, Cong Martin, 38050 GRENOBLE CEDEX 9 (FR)
(74) Mandataire: Brevalex

(56) Documents cités:
- WO-A2-2004/034428
- DE-T5-112012 003 296
- US-A- 6 072 240
- US-A1- 2011 024 896
- US-A1- 2013 020 694

## Description

### DOMAINE TECHNIQUE

L'invention se rapporte au domaine des dispositifs électroniques de puissance et plus particulièrement aux modules électroniques de puissance.

### ÉTAT DE LA TECHNIQUE ANTÉRIEURE

Pour la fourniture de certaines fonctions, telles que le découpage d'un signal électrique, il est connu d'équiper les circuits moyenne et basse tension de dispositifs électroniques de puissance, tels que des modules électroniques de puissance. De tels modules de puissance comportent chacun une pluralité de composants électriques de puissance, tels que des diodes ou des transistors bipolaires à grille isolée, plus connus sous leur sigle anglais IGBT, arrangés ensemble pour former un sous-circuit électrique du circuit électrique équipé.

Plus précisément, un tel module électronique de puissance comporte, en plus de la pluralité de composants, un support pour supporter les composants et connecter un de leurs contacts de puissance et une plaque de connexion pour connecter l'autre contact de puissance des composants et au moins un de leurs contacts de commande lorsqu'ils en comportent. De cette manière, les composants sont intégrés dans un seul module avec deux surfaces d'échange thermique pour évacuer la chaleur dégagée par les composants en fonctionnement, à savoir celles du support et de la plaque de connexion.

Néanmoins, dans une telle configuration, la majeure partie de la chaleur est évacuée au travers du support. En effet, les connexions entre chaque composant et la plaque de connexion définissent une surface de contact thermique bien inférieure à celle entre chaque composant et le support. Il en résulte une évacuation de chaleur présentant une efficacité réduite et des problèmes mécaniques liés à la différence de température entre le support et la plaque de connexion et de la différence de dilatation thermique qui en résulte.

Afin d'améliorer la distribution en température et optimiser l'évacuation de la chaleur dégagée par les composants des modules électroniques, il est connu du document US2013/020694 A1 de fournir un module comportant un premier et un deuxième support sur lesquels sont disposés les composants électroniques. Dans l'agencement de modules divulgué dans ce document, chaque composant présente une première face sur laquelle est disposé un premier contact de puissance et par laquelle il est supporté par l'un des supports, et une deuxième face sur laquelle est disposé un deuxième contact de puissance par lequel il est connecté à l'autre support. Dans un tel module, les composants d'un même type sont connectés en série avec un premier composant supporté sur le premier support et un deuxième composant supporté sur le deuxième support. De cette manière en fonctionnement, le premier composant présente un contact thermique prépondérant avec le deuxième support et le deuxième composant présente un contact thermique prépondérant avec le deuxième support.

Il en résulte qu'un tel module présente deux surfaces d'échange thermique pour évacuer la chaleur dégagée par les composants en fonctionnement avec une répartition thermique relativement équilibrée entre le premier et le deuxième support.

Néanmoins, un tel module présente un certain nombre d'inconvénients en ce qui concerne la répartition thermique entre les supports et les connexions admissibles entre composants. En effet, l'équilibrage de la répartition thermique d'un tel module n'est pas toujours vrai, car il y a bien souvent des cas où les deux composants ne fonctionnent pas de manière symétrique ou équilibrée, ce qui peut entraîner un déséquilibrage thermique. De plus, selon le principe exposé dans le document US2013/020694 A1 les contraintes vis-à-vis du circuit électrique admissible sont fortes puisqu'il faut nécessairement que les composants soient montés en série pour équilibrer la répartition de chaleur.

### EXPOSÉ DE L'INVENTION

L'invention vise à résoudre ces inconvénients et a ainsi pour but de fournir un module électronique de puissance qui, tout en présentant une configuration facilitant l'évacuation équilibrée de chaleur quel que soit la configuration de fonctionnement, ne soit pas limité quant aux circuits électriques admissibles..

L'invention concerne à cet effet un module électronique de puissance selon la revendication 1. Un tel module présente une bonne évacuation de la chaleur dégagée en fonctionnement avec une répartition thermique équilibrée entre le premier et le deuxième support tout en laissant la possibilité de connexion relativement complexe entre ses différents composants. En effet, pour chaque paire de composants la surface d'échange thermique entre le premier composant et le premier support est sensiblement identique à celle entre le deuxième composant et le deuxième support et permet une répartition équilibré entre les deux supports étant donné que le premier et le deuxième composant sont redondants et fonctionnent en parallèle. De plus, un tel montage ne limite en rien les circuits admissibles pour un tel module, tout composant pouvant être remplacé par une paire équivalente de composants fonctionnant en parallèle.

On entend ci-dessus et dans le reste de ce document par « le premier et deuxième composant présentent un agencement redondant », le fait que le premier et deuxième composant présentent un agencement équivalant dans lequel ils fonctionnent en parallèle et avec des conditions sensiblement identiques.

On entend ci-dessous et dans le reste de ce document par «de manière à fonctionner en parallèle » que le premier et le deuxième composant sont montés soit directement en parallèle l'un de l'autre soit selon un montage dans lequel le premier et le deuxième composant sont compris dans deux branches du circuit équivalente parallèle l'une à l'autre. Ainsi, une telle configuration inclus par exemple un montage de deux paires de composants dans laquelle les premiers composants des deux paires sont en série l'un avec l'autre en parallèle avec les deuxièmes composants des deux paires également en série l'un avec l'autre.

On entend ci-dessus et dans le reste de ce document par « composants sensiblement identiques » que les composants présentent des caractéristiques identiques aux tolérances près.

Le premier et le deuxième composants peuvent être montés parallèle l'un à l'autre.

Chacun des composants peut être connecté au circuit électrique de l'autre support que celui les supportant au moyen de ponts de soudure tels que par exemple ceux obtenus par soudure ou brasage à billes.

La première face de chacun des composants peut être fixée au support le supportant par du matériau de soudure ou de brasage.

De tels moyens de connexion et de fixation permettent pour les premiers une connexion rapide et fiable des composants aux pistes conductrices, et pour les autres une fixation solide des composants. Un module comportant ces deux types de moyens pourra être aisément fabriqué tout en présentant des connexions électriques et thermiques fiables.

Les composants d'au moins une paire peuvent comporter chacun au moins un contact de commande et au moins deux contacts de puissance, le contact de commande étant disposé sur la deuxième face et au moins un premier contact de puissance étant disposé sur la première face, le circuit électrique de chacun du premier et du deuxième support pouvant comporter au moins une première piste conductrice de circuit haute puissance, dite piste de puissance, et une piste conductrice de commande, dite piste de commande,
et les composants de l'au moins une paire pouvant être agencés sur le support correspondant avec le contact de puissance de la première face en contact sur une piste haute puissance et avec le contact de commande connecté à une piste de commande de l'autre support que celui sur lequel le composant est supporté.

Avec une telle configuration du module, la connexion d'une paire de composants comportant un contact de commande, tel qu'un interrupteur commandé, est facilitée.

La piste commande du premier support peut présenter une portion de piste qui fait face à la première piste de puissance du deuxième support et la piste de commande du deuxième support peut présenter une portion de piste fait face à la première piste de puissance du premier support.

Avec une telle configuration, le placement d'un composant comportant un contact de commande sur sa deuxième face vis-à-vis des pistes de puissance et de commande du premier et du deuxième support est optimisé.

Le deuxième contact de puissance de chacun des composants comportant un contact de commande peut être disposé sur la deuxième face du composant, le premier et le deuxième support pouvant comporter chacun au moins une deuxième piste de puissance, les composants comportant un contact de commande pouvant avoir chacun leur deuxième contact de commande connecté à la deuxième piste de puissance de l'autre support que celui sur lequel le composant est supporté.

La deuxième piste de puissance du premier support peut comporter une portion de piste qui fait face à la première piste de puissance du deuxième support, la deuxième piste de puissance du deuxième support comportant une portion de piste faisant face à la première piste de puissance du premier support.

L'invention concerne également un procédé de fabrication d'un module électronique de puissance selon la revendication 8. Les étapes de montages du chaque premier et deuxième composant sur respectivement le premier et le deuxième support peut être une étape de brasage ou de soudage de chacun desdits premier et deuxième composants.

lors de l'étape d'assemblage du premier et du deuxième, il peut être prévu une sous-étape de mise en place de billes de soudage et une sous étape de chauffage pour obtenir un soudage à billes avec lesdites billes de soudage.

De tels procédés permettent la fabrication de modules selon l'invention qui bénéficient donc des avantages correspondants.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un exemple de module haute puissance selon l'invention dont un premier et un deuxième support sont séparés pour montrer le montages de composants hautes puissances sur chacun des supports,
- la figure 2 illustre schématiquement le circuit équivalent du module illustré sur la figure 1,
- les figures 3A et 3B illustrent respectivement le circuit électrique d'un premier et d'un deuxième support du module illustré sur la figure 2 avec les composants qu'il supporte, les composants auxquels ils sont connectés étant figurés par leur contour,
- la figure 4 illustre schématiquement la répartition de la chaleur en fonctionnement du module illustré sur la figure 1,
- les figures 5A à 5D illustrent les principales étapes de fabrication d'un module tel qu'illustré sur la figure 1,

Des parties identiques, similaires ou équivalentes des différentes figures portent les mêmes références numériques de façon à faciliter le passage d'une figure à l'autre.

Pour rendre les figures plus lisibles, les différentes parties représentées sur les figures ne le sont pas nécessairement selon une échelle uniforme..

### EXPOSÉ DÉTAILLÉ DE MODES DE RÉALISATION PARTICULIERS

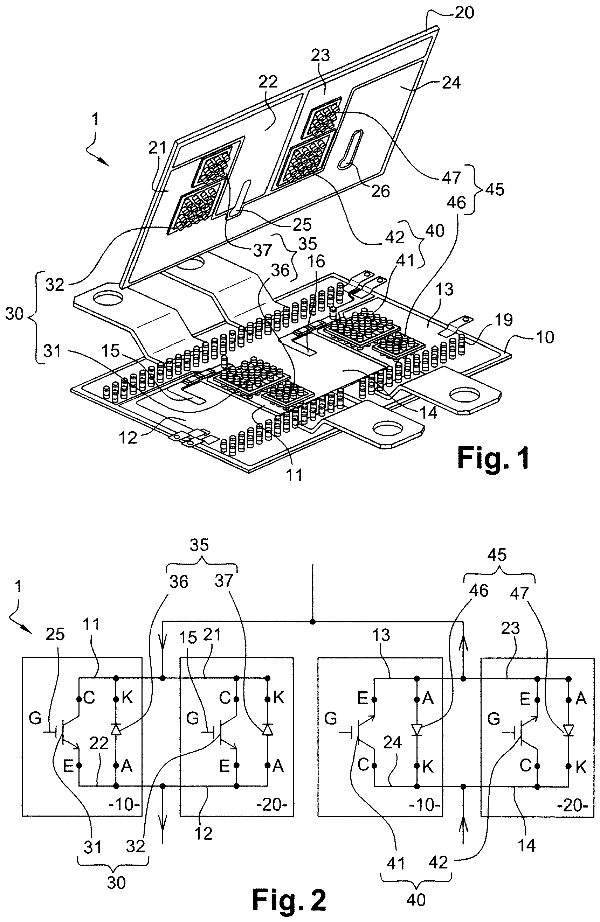

La figure 1 illustre une vue en perspective d'un module 1 électronique de puissance selon l'invention dans lequel un premier et un deuxième support 10, 20 sont séparés afin de montrer des composants 31, 32, 36, 37, 41, 42, 46, 47 électroniques de puissances qui sont disposés sur ces deux supports 10, 20.

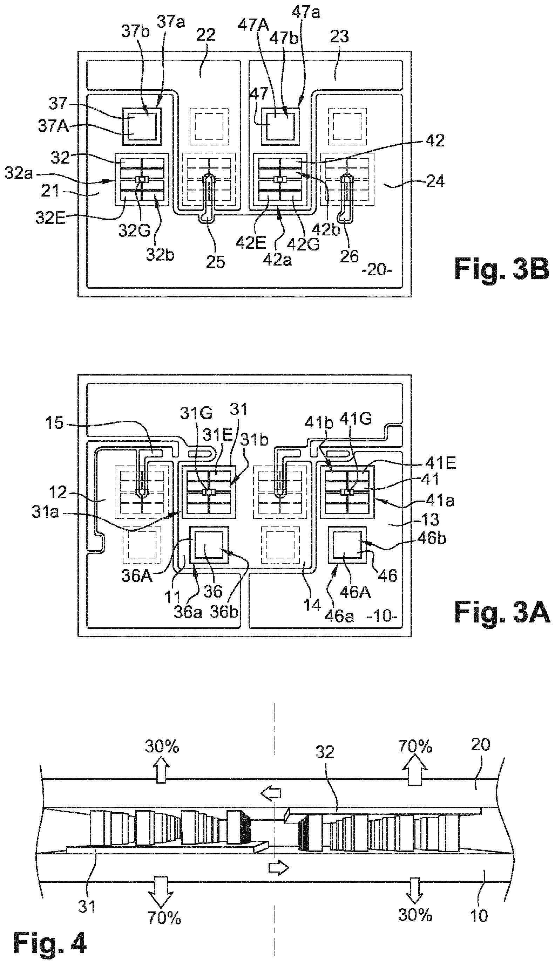

En faisant référence aux figures 3A et 3B, un tel module 1 comporte :
- un premier et un deuxième support 10, 20 comportant chacun un circuit électrique sur leur face intérieure, c'est-à-dire celle qui fait face respectivement à l'autre support 20, 10.
- une pluralité de paires 30, 35, 40, 45 de composants 31, 32, 36, 37, 41, 42, 46, 47, chacune des paires 30, 35, 40, 45 comportant un premier et un deuxième composant 31, 36, 41, 46, 32, 37, 42, 47 sensiblement identiques et chacun des composants 31, 32, 36, 37, 41, 42, 46, 47 comportant une première face 31a, 32a, 36a, 37a, 41a,42a, 46a, 47a supportée pour les uns 31, 36, 41, 46 sur le premier support 10 et pour les autres 32, 37, 42, 47 sur le deuxième support 20 et une deuxième face 31b, 32b, 36b, 37b connectée à un circuit électrique pour les uns du deuxième support 20 et pour les autres du premier support 10.
les deux composants 31, 32, 36, 37, 41, 42, 46, 47 d'une paire 30, 35, 40, 45présentent un agencement redondant, le premier composant 31, 36, 41, 46 de ladite paire 30, 35, 40, 45 étant supporté par le premier support 10 et connecté au deuxième circuit électrique, le deuxième composant 32, 37, 42, 47 étant supporté par le deuxième support 20 et connecté au premier circuit électrique de manière à fonctionner en parallèle du premier composant 31, 36, 41, 46 de ladite paire 30, 35, 40, 45.La figure 2 illustre schématiquement le sous-circuit formé par le module 1 qui reproduit une configuration classique de la mise en série de deux interrupteurs, plus connue sous sa dénomination anglaise « dual switch », dans laquelle chaque interrupteur a été doublé par deux interrupteurs montés en parallèle. Ainsi le module 1 comporte plus précisément :
- une première et une deuxième paire 30, 40 d'IGBT,
- une première et une deuxième paire 35, 45 de diodes associées respectivement à la première et la deuxième paire 30,40 d'IGBT.

La première face 31a, 32a, 41a, 42a de chacun des IGBT 31, 32, 41, 42 comporte un premier contact de puissance 31C, 32C, 41C, 42C correspondant au collecteur de l'IGBT 31, 32, 41, 42. Le premier contact de puissance 31C, 32C, 41C, 42C représente la majeure partie de la surface de la première face 31a, 32a, 41a, 42a de l'IGBT 31, 32, 41, 42. La deuxième face 31b, 32b, 41b, 42b de chacun des IGBT 31, 32, 41, 42 comporte un deuxième contact de puissance 31E, 32E, 41E, 42E correspondant à l'émetteur de l'IGBT et un contact de commande 31G, 32G, 41G, 42G correspondant à la grille de l'IGBT. Le contact de commande 31G, 32G, 41G, 42G est arrangé sur la deuxième face 31b, 32b, 41b, 42b de chaque IGBT 31, 32, 41, 42 sous la forme d'un unique plot de contact central. Le deuxième contact de puissance 31E, 32E, 41E, 42E est arrangé sur la deuxième face 31b, 32b, 41b, 42b de chacun des IGBT 31, 32, 41, 42 sous la forme de plots de contact périphériques. Ainsi, on peut voir sur les figures 3A et 3B que les IGBT 31, 32, 41, 42 comportent chacun 8 plots de contacts de puissance 31E, 32E, 41E, 42E entourant l'unique plot de contact de commande 31G, 32G, 41G, 42G.

La première face 36a, 37a, 46a, 47a de chacune des diodes 36, 37, 46, 47 comporte un premier contact de puissance 36K, 37K, 46K, 47K formant cathode. Le premier contact de puissance 36K, 37K, 46K, 47K représente la majeure partie de la surface de la première face 36a, 37a, 46a, 47a de la diode 36, 37, 46, 47. La deuxième face 36b, 37b, 46b, 47b de chacune des diodes 36, 37, 46, 47 comporte un deuxième contact de puissance 36A, 37A, 46A, 47A formant anode. Le deuxième contact de puissance 36A, 37A, 46A, 47A représente la majeure partie de la surface de la deuxième face 36b, 37b, 46b, 47b de la diode 36, 37, 46, 47.

L'agencement des premières et deuxièmes paires 30, 40, 35, 45 d'IGBT et de diodes est illustré sur les figures 1 et 2.

Ainsi on peut voir sur les figures 1 et 2 que pour les premières paires 30, 35 d'IGBT et de diodes :
- les premiers contacts de puissance 31C, 36K du premier IGBT 31 et de la première diode 36 sont électriquement connectés ensemble par une première piste de puissance 11,
- les deuxièmes contacts de puissance 31E, 36A du premier IGBT 31 et de la première diode 36 sont électriquement connectés ensemble par une deuxième piste de puissance 22,
- le contact de commande 31G du premier IGBT 31 est connecté à une première piste de commande 25,
- les premiers contacts de puissance 32C, 37K du deuxième IGBT 32 et de la deuxième diode 37 sont reliés ensemble par une troisième piste de puissance 21,
- les deuxièmes contacts de puissance 32E, 37A du deuxième IGBT 32 et de la deuxième diode 37 sont électriquement connectés ensemble par une quatrième piste de puissance 12,
- le contact de commande 32G du premier IGBT 32 est connecté à une deuxième piste de commande 15.

De cette manière le premier et le deuxième IGBT 31, 32 de la première paire d'IGBT30 sont montés en parallèle selon un agencement redondant ceci de manière à fonctionner en parallèle l'un avec l'autre. De la même façon, la première et la deuxième diode 36, 37 de la première paire de diode 35 sont montées en parallèle selon un agencement redondant ceci de manière à fonctionner en parallèle l'une avec l'autre.

De même, comme on peut voir sur les figures 1 et 2, pour les deuxièmes paires 40, 45 d'IGBT 41, 42 et de diodes 46, 47 :
- les premiers contacts de puissance 41C, 46K du premier IGBT 41 et de la première diode 46 sont électriquement connectés ensemble par une cinquième piste de puissance 13,
- les deuxièmes contacts de puissance 41E, 46A du premier IGBT 41 et de la première diode 46 sont électriquement connectés ensemble par une sixième piste de puissance 24,
- le contact de commande 41G du premier IGBT 41 est connecté à une troisième piste de commande 26,
- les premiers contacts de puissance 42C, 47K du deuxième IGBT 42 et de la deuxième diode 47 sont reliés ensemble par une septième piste de puissance 23,
- les deuxièmes contacts de puissance 42E, 47A du deuxième IGBT 42 et de la deuxième diode 47 sont électriquement connectés ensemble par une huitième piste de puissance 14,
- le contact de commande 42G du premier IGBT 42 est connecté à une quatrième piste de commande 16.

De cette manière le premier et le deuxième IGBT 41, 42 de la deuxième paire d'IGBT 40 sont montés en parallèle selon un agencement redondant ceci de manière à fonctionner en parallèle l'un avec l'autre. De la même façon, la première et la deuxième diode 46, 47 de la deuxième paire de diode 45 sont montées en parallèle selon un agencement redondant ceci de manière à fonctionner en parallèle l'une avec l'autre.

De tels agencements des premières et deuxièmes paires 30, 40, 35, 45 d'IGBT 31, 32, 41, 42 et de diodes 36, 37, 46, 47 sont réalisés aux moyens du premier et deuxième circuit électrique, respectivement du premier et deuxième support 10, 20.

Pour ce faire et en référence aux figures 1 et 3A, le premier circuit électrique du premier support 10 comporte sur sa face intérieure les première, quatrième, cinquième et huitième pistes de puissance 11, 12, 13, 14 et les première et troisième pistes de commande 15, 16. Le deuxième circuit du deuxième support 12 comporte, comme illustré sur les figures 1 et 3B, les deuxième, troisième, sixième, septième pistes de puissance 21, 22, 23, 24 et les deuxième et quatrième pistes de commande 25, 26.

Il est à noter que les première et huitième pistes de puissance 11, 14 sont reliées l'une à l'autre et se confondent pour former une seule piste. De même, les deuxième et septième pistes de puissance 21, 24 sont reliées l'une à l'autre et se confondent pour former une seule et même piste.

Les première et cinquième pistes de puissances 11, 13 sont agencées sur le premier support 10 de manière à ce qu'un IGBT 31, 41 et une diode 36, 46 supportés par leur première face 31a, 41a en connexion électrique sur ces derniers, l'IGBT 31, 41 et la diode 36, 46 présentent leur deuxième contact de puissance 31E, 41E, 36A, 46A en regard d'une piste de puissance 22, 24 du deuxième support 20, et que l'IGBT 31, 41 présente son contact de commande 31G, 41G en regard d'une piste de commande du deuxième 25,26 support 20. En d'autres termes, la première piste de puissance 11 fait face à la deuxième piste de puissance 22 et la première piste de commande 25 et la cinquième piste de puissance 13 fait face à la sixième piste de puissance 24 et la troisième piste de commande 26.

Ainsi, les premiers IGBT 31, 41 et diodes 36, 46 des premières et deuxièmes paires d'IGBT 30, 40 et de diodes 35, 45 en étant supportés par leur première face 31a, 41a, 36a, 46a sur le premier support 10 connectés aux pistes de puissances 21, 23 de ce dernier peuvent aisément être connectés par leur deuxième face 31b, 41b, 36b, 46b au circuit électrique du deuxième support 20. Une telle connexion peut être fournie, comme cela est illustré sur la figure 1, par un soudage à billes 19.

De même les troisième et septième pistes de puissance 21, 23, sont agencées sur le deuxième support 20 de manière à ce que lorsqu'un IGBT 32, 42 et une diode 37, 47 sont supportés par leur première face en connexion électrique sur ces derniers, l'IGBT 32, 42 et la diode 37, 47 présente leur deuxième contact de puissance 32E, 42E, 37A, 47A en regard d'une même piste de puissance 12, 13 du premier support 10 et que l'IGBT 32, 42 présente son contact de commande 32G, 42G en regard d'une piste de commande 15, 16 du premier support 10. En d'autres termes, la troisième piste de puissance 21 présente une portion de piste qui fait face à la quatrième piste de puissance 12 et la deuxième piste de commande 15 et la septième piste de puissance 23 présente une portion de piste qui fait face à la huitième piste de puissance 14 et la quatrième piste de commande 16.

Ainsi, les deuxièmes IGBT 32, 42 et diodes 37, 47 des premières et deuxièmes paires d'IGBT 30, 40 et de diodes 35, 45 en étant supportés par leur première face 32a, 42a, 37a, 47a sur le deuxième support 20 connectés aux pistes de puissances 21, 23 de ce dernier peuvent aisément être connectés par leur deuxième face 32b, 42b, 37b, 47b au circuit électrique du premier support 10.

Il est à noter que pour permettre une connexion des première et huitième pistes de puissance 11, 14 du premier support 10 avec les troisième et sixième pistes de puissance 21, 24 du deuxième support 20, la première et la huitième piste de puissance 11, 14 comporte respectivement une portion de piste faisant face à respectivement la troisième et sixième piste de puissance 21, 24. De même, pour permettre la connexion entre des quatrième et cinquième piste de puissance 12, 13 du premier support 10 avec respectivement les deuxième et septième piste de puissance 22, 23 du deuxième support, la quatrième et la cinquième piste 12, 13 de puissance comporte respectivement, une portion de piste faisant face à respectivement la deuxième et septième piste de puissance 22, 23.

Ainsi les connexions entre les pistes de puissance 11, 12, 13, 14, 21, 22, 23, 24 du premier et du deuxième support 10 20 peuvent être réalisées par une méthode de connexion simple telle qu'un soudage par billes 19 comme cela est illustré sur la figure 1.

De même, pour permettre la commande simultanée du premier et du deuxième IGBT 31, 41, 32, 42 d'une même paire d'IGBT 30, 40, la première et la troisième piste de commande 15, 16 comporte chacune une portion de piste faisant face à respectivement la deuxième et la quatrième piste de commande 25, 26. De cette manière, la première et la troisième piste de commande 15, 16 peuvent être connectées à respectivement la deuxième et quatrième piste de commande 25, 26 par une méthode de connexion simple telle qu'un soudage à billes comme cela est illustré sur la figure 1.

Un tel module, comme illustré sur la figure 1, présente donc pour le premier composant 31, 36, 41, 46 de chacune des paires 30, 35, 40, 45 une surface de contact thermique avec le premier support 10 plus importante que la surface de contact thermique avec le deuxième support 20. En effet, la surface de contact thermique sur le premier support 10 est fournie par une fixation de la première face 31a, 36a, 41a, 46a du premier composant 31, 37, 41, 47 sur une piste de puissance du premier 11, 13 support 10 tandis qu'elle est fournie pour le contact thermique avec le deuxième support 20 par des connexions électriques simples telles que des billes 19 de soudages . Il en résulte que le premier composant 31, 36, 41, 46 de chacune des paires 30, 35, 40, 45 présente une surface de contact thermique généralement 5 fois, voire 10 fois, plus grande avec le premier support 10 qu'avec le deuxième support 20.

Réciproquement, et de la même manière, le deuxième composant 32, 37, 42, 47 de chacune des paires 30, 35, 40, 45 présente une surface de contact thermique avec le deuxième support 20 d'une surface plus importante que la surface de contact thermique avec le premier support 10. Ainsi, le deuxième composant 32, 36, 42, 47 de chacune des paires 30, 35, 40, 45 présente une surface de contact thermique généralement 5 fois, voire 10 fois, plus grande avec le deuxième support 20 qu'avec le deuxième support 10.

Le premier et le deuxième composants 31, 36, 41, 46, 32, 37, 42, 47 d'une même paire 30, 35, 40, 45 fonctionnant en parallèle, comme le montre la figure 2, il en résulte comme l'illustre la figure 4, qu'en fonctionnement, la quantité de chaleur transmise par l'un du premier et du deuxième composant 31, 36, 41, 46, 32, 37, 42, 47 à l'un du premier et du deuxième support 10, 20 équilibre celle transmise par l'autre du premier et du deuxième composant 31, 36, 41, 46, 32, 37, 42, 47 à l'autre du premier et du deuxième support 10, 20. Ainsi, le premier et le deuxième support 10, 20, comme le montre la figure 4, reçoivent la même quantité d'énergie thermique. Il en résulte une dissipation thermique sensiblement identique à celle des modules où les composants sont connectés thermiquement aux deux supports 10, 20.

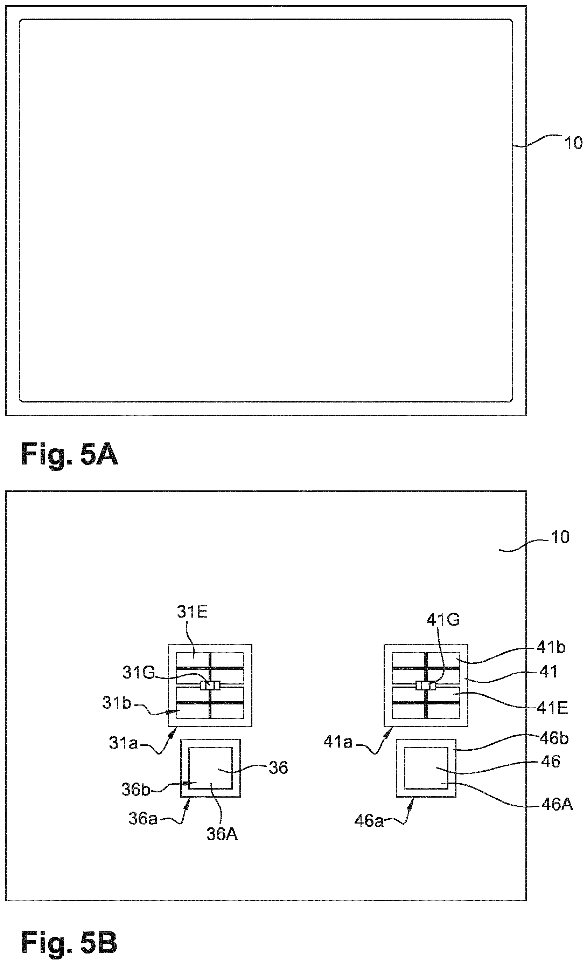

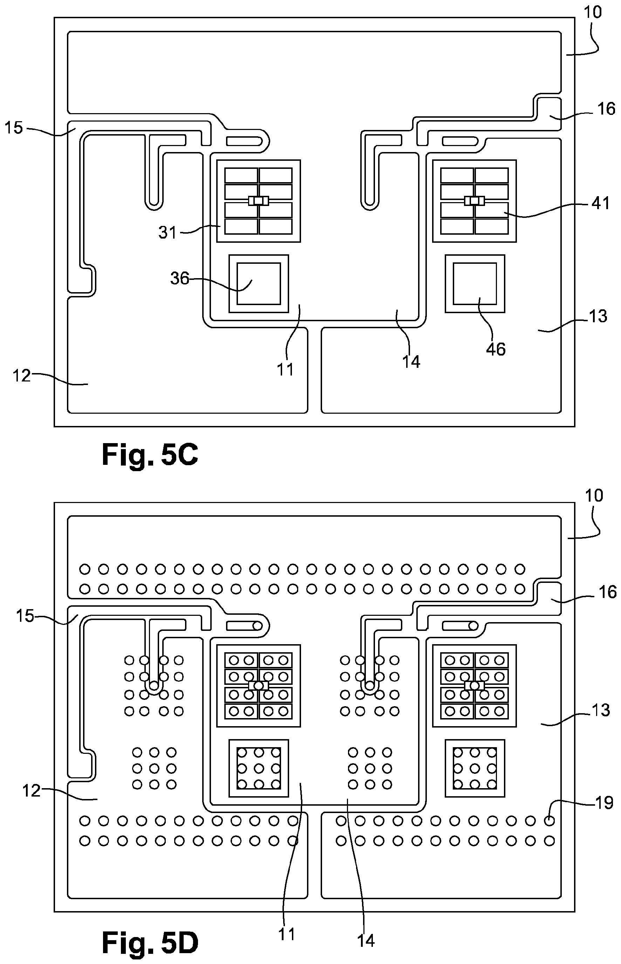

Un tel module peut être fabriqué avec un procédé comportant les étapes suivantes :
- fourniture du premier et du deuxième support 10, 20, chacun comportant une face conductrice, comme celle illustrée sur la figure 5A, dans laquelle il peut être formé des pistes de conduction, telles des pistes de puissance ou de commande,
- fourniture des composants de puissance 31, 32, 36, 37, 41, 42, 46, 47 par paire 30, 35, 40, 45,
- fixation par leur première face 31a, 32a, 36a, 37a, 41a, 42a, 46a, 47a des composants 31, 32, 36, 37, 41, 42, 46, 47 sur la face conductrice des supports 10, 20, le premier composant 31, 36, 41, 46 de chaque paire 30, 35, 40, 45 sur le premier support 10 et le deuxième composant 32, 37, 42, 47 de chaque paire 30, 35, 40, 45 sur le deuxième support, comme cela est illustré sur la figure 5B pour le premier support 10,
- formation des pistes de puissances et de commande 11, 12, 13, 14, 15, 16, 21, 22, 23, 24, 25, 26 sur la face conductrice de chacun des supports 10, 20, tel que cela est illustré sur la figure 5C pour le deuxième support 20
- formation des billes 19 pour la soudure à billes, sur les deuxièmes faces des composants et sur les pistes de puissances et de commande des supports, tel que cela est illustré sur la figure 5D,
- assemblage du premier et du deuxième support de manière à mettre les pistes de puissance et de commande du premier support et du deuxième support en regard respectivement, tel que cela est visible sur la figure 1 avant fermeture du module 1,
- chauffage pour obtenir le soudage à billes des composants 31, 32, 36, 37, 41, 42, 46, 47 sur les pistes de puissance et de commande 11, 12, 13, 14, 21, 22, 23, 24, 15, 16, 25, 26 de l'autre support 10, 20 que celui sur lequel les composants 31, 32, 36, 37, 41, 42, 46, 47 sont supportés.

Lors de l'étape de fixation des composants par leur première face sur la face conductrice du support correspondant, cette fixation peut être réalisée aussi bien par brasage que par soudage. Ainsi chacun des composants peut être fixé au support le supportant soit par du matériau de brasage soit par du matériau de soudage.

De même, il est prévu dans le procédé une étape de mise en place de billes de soudage, un assemblage des supports et une étape de chauffage pour obtenir le soudage à billes. Il est néanmoins également envisageable, ceci sans sortir du cadre de l'invention, de connecter les composants à l'autre support que celui qui les supporte par une méthode différente telle que l'utilisation de ponts de soudage autres que des billes de soudage

On peut également noter que dans le mode de réalisation décrit ci-dessus, si il est prévu deux paires d'IGBT et deux paire de diodes, le principe de l'invention peut s'appliquer à d'autres types de modules comportant un nombre quelconque d'interrupteurs, avec des composants différents répartis en un nombre de paires différent. Ainsi l'invention peut s'appliquer à un module comportant uniquement une paire d'IGBT ou des modules avec des structures beaucoup plus complexes.

## Revendications

1. Module (1) électronique de puissance comportant :
- une pluralité de composants (31, 32, 36, 37, 41, 42, 46, 47) électroniques de puissance,
- un premier et un deuxième support (10, 20) agencés sensiblement parallèlement l'un par rapport à l'autre et qui comportent respectivement un premier et un deuxième circuit électrique,
dans lequel les composants (31, 32, 36, 37, 41, 42, 46, 47) sont agencés par paire (30, 35, 40, 45) comprenant chacune un premier composant (31,36,41,46) et un deuxième composant (32,37,42,47) sensiblement identiques, dans lequel chaque premier composant (31, 36, 41, 46) comporte une première face (31a, 36a, 41a, 46a) adaptée pour être supportée sur le premier support (10) en contact électrique avec le premier circuit électrique du premier support (10), et une deuxième face (31b, 36b, 41b, 46b) adaptée pour être connectée électriquement à un autre circuit électrique avec une surface de contact thermique inférieure à celle entre la première face (31a, 36a, 41a, 46a) et le premier support (10),
dans lequel chaque deuxième composant (32, 37, 42, 47) comporte une première face (32a, 37a, 42a, 47a) adaptée pour être supportée sur le deuxième support (20) en contact électrique avec le deuxième circuit électrique du deuxième support (20), et une deuxième face (32b, 37b, 42b, 47b) adaptée pour être connectée électriquement à un autre circuit électrique avec une surface de contact thermique inférieure à celle entre la première face (32a, 37a, 42a, 47a) et le deuxième support (20),
le module (1) **étant caractérisé en ce que,** chaque premier composant (31, 36, 41, 46) d'une paire (30, 35, 40, 45) est supporté au moyen de sa première face (31a, 36a, 41a, 46a) par le premier support (10) en contact électrique avec le premier circuit électrique et est connecté par sa deuxième face (31b, 36b, 41b, 46b) au deuxième circuit électrique,
et **en ce que** chaque deuxième composant (32, 37, 42, 47) d'une paire (30, 35, 40, 45) est supporté au moyen de sa première face (32a, 37a, 42a, 47a) par le deuxième support (20) en contact électrique avec le deuxième circuit électrique et connecté par sa deuxième face (32b, 37b, 42b, 47b) au premier circuit électrique de manière à présenter un agencement équivalent au premier composant (31, 36, 41, 46) de ladite paire (30, 35, 40, 45) en fonctionnant en parallèle du premier composant (31, 36, 41, 46) dans des conditions identiques.

2. Module (1) selon la revendication 1, dans lequel chacun des composants (31, 32, 36, 37, 41, 42, 46, 47) est connecté au circuit électrique de l'autre support (10, 20) que celui les supportant au moyen de ponts de soudure tels que par exemple ceux obtenus par soudure ou brasage à billes.

3. Module (1) selon la revendication 1 ou 2, dans lequel la première face (31a, 32a, 36a, 37a, 41a, 42a, 36a, 37a) de chacun des composants (31, 32, 36, 37, 41, 42, 46, 47) est fixée au support (10, 20) le supportant par du matériau de soudure ou de brasage.

4. Module (1) selon l'une quelconque des revendications 1 à 3, dans lequel les composants (31, 32, 41, 42) d'au moins une paire (30, 40) comportent chacun au moins un contact de commande (31G, 32G, 41G, 42G) et au moins deux contacts de puissance (31C, 31E, 31C, 32E, 41C, 41E, 42C, 42E), le contact de commande (31G, 32G, 41G, 42G) étant disposé sur la deuxième face (31b, 32b, 41b, 42b) et au moins un premier contact de puissance (31C, 32C, 41C,42C) étant disposé sur la première face (31a, 32a, 41a, 42a), le circuit électrique de chacun du premier et du deuxième support (10, 20) comportant au moins une première piste (11, 12, 13, 14, 21, 22, 23, 24) conductrice de circuit haute puissance, dite piste de puissance, et une piste (15, 16, 25, 26) conductrice de commande, dite piste de commande,
et dans lequel les composants (31, 32, 41, 42) de l'au moins une paire (30, 40) sont agencés sur le support (10, 20) correspondant avec le contact de puissance (31C, 32C, 41C, 42C) de la première face (31a, 32a, 41a, 42a) en contact sur une piste haute puissance (11, 21, 14, 24) et avec le contact de commande (31G, 32G, 41G, 42G) connecté à une piste de commande (25, 15, 26, 16) de l'autre support (20,10) que celui sur lequel le composant (31, 32, 41, 42) est supporté.

5. Module (1) selon la revendication 4, dans lequel la piste commande (15, 16) du premier support (10) présente une portion de piste qui fait face à la première piste de puissance (21, 23) du deuxième support (20) et dans lequel la piste de commande (25, 26) du deuxième support (20) présente une portion de piste qui fait face à la première piste de puissance (11, 13) du premier support (10).

6. Module (1) selon la revendication 5, dans lequel le deuxième contact de puissance (31E , 32E, 41E, 42E) de chacun des composants (31, 32, 41, 42) comportant un contact de commande (31G, 32G, 41G, 42G) est disposé sur la deuxième face (31a, 32a, 41a, 42a) du composant (31, 32, 41, 42), le premier et le deuxième support (10, 20) comportant chacun au moins une deuxième piste de puissance (12, 14, 22, 24), les composants (31, 32, 41, 42) comportant un contact de commande (31G, 32G, 41G, 42G) ayant chacun leur deuxième contact de commande (31E, 32E, 41E, 42E) connecté à la deuxième piste de puissance (12, 14, 22, 24) de l'autre support (20,10) que celui sur lequel le composant (31, 32, 41, 42) est supporté.

7. Module électronique selon la revendication 6, dans lequel la deuxième piste de puissance (12, 14) du premier support (10) comporte une portion de piste qui fait face à la première piste de puissance (21, 23) du deuxième support (20), la deuxième piste de puissance (22, 24) du deuxième support (20) comportant une portion de piste faisant face à la première piste de puissance (11, 13) du premier support (10).

8. Procédé de fabrication d'un module (1) électronique de puissance comportant les étapes suivantes :
- fourniture d'un premier et d'un deuxième support (10, 20) comportant respectivement un premier et un deuxième circuit électrique,
- fourniture d'une pluralité de composants (31, 32, 36, 37, 41, 42, 46, 47) électroniques de puissance, chaque composant (31, 32, 36, 37, 41, 42, 46, 47) comportant une première face (31a, 32a, 36a, 37a, 41a, 42a, 36a, 37a), destinée à être supportée sur un support (10, 20) en contact électrique avec un circuit électrique du support (10,20), et une deuxième face (31b, 32b, 36b, 37b, 41b, 42b, 46b, 47b) destinée à être connectée électriquement à un autre circuit électrique avec une surface de contact thermique inférieure à celle entre la première face (31a, 32a, 36a, 37a, 41a, 42a, 36a, 37a) et le support (10, 20), les composants (31, 32, 36, 37, 41, 42, 46, 47) étant destinée à être agencé par paire (30, 35, 40, 45) comportant chacune un premier composant (31,36,41,46) et un deuxième composant (32,37,42,47) sensiblement identiques,
- montage de chaque premier composant (31, 36, 41, 46) sur le premier support (10) de manière à ce qu'il ait sa première face (31a, 36a, 41a, 46a) supportée par le premier support (10) en contact électrique avec le premier circuit électrique,
- montage de chaque deuxième composant (32, 37, 42, 47) sur le deuxième support (20) de manière à ce qu'il ait sa première face (32a, 37a, 42a, 47a) supportée par le deuxième support (20) en contact électrique avec le deuxième circuit électrique,
- assemblage du premier et du deuxième support (10, 20) en connectant électriquement la deuxième face (31b, 36b, 41b, 46b) de chaque premier composant (31, 36, 41, 46) au deuxième circuit électrique du deuxième support (20) et en connectant électriquement la deuxième face (32b, 37b, 42b, 47b) de chaque deuxième composant (32, 37, 42, 47) au premier circuit électrique du premier support (10) de manière à fonctionner en parallèle au premier composant (31, 36, 41, 46) correspondant.

9. Procédé de fabrication selon la revendication 8, dans lequel les étapes de montages de chaque premier composant (31,36,41,46) et de chaque deuxième composant (32,37,42,47) sur respectivement le premier et le deuxième support (10, 20) est une étape de brasage ou de soudage de chacun desdits premier composants (31,36,41,46) et deuxième composants (32,37,42,47).

10. Procédé de fabrication selon la revendication 9, dans lequel lors de l'étape d'assemblage du premier et du deuxième support (10, 20), il est prévu une sous-étape de mise en place de billes de soudage (19) et une sous étape de chauffage pour obtenir un soudage à billes avec lesdites billes de soudage (19).

## Patentansprüche

1. Elektronisches Leistungsmodul (1), enthaltend:
- eine Mehrzahl von elektronischen Leistungsbauteilen (31, 32, 36, 37, 41, 42, 46, 47),
- einen ersten und einen zweiten Träger (10, 20), die im Wesentlichen parallel zueinander angeordnet sind und einen ersten bzw. einen zweiten Stromkreis aufweisen,
wobei die Bauteile (31, 32, 36, 37, 41, 42, 46, 47) in Paaren (30, 35, 40, 45) angeordnet sind, die jeweils ein erstes Bauteil (31, 36, 41, 46) und ein zweites Bauteil (32, 37, 42, 47) aufweisen, die im Wesentlichen identisch sind,
wobei jedes erste Bauteil (31, 36, 41, 46) eine erste Seite (31a, 36a, 41a, 46a) aufweist, die dazu ausgelegt ist, am ersten Träger (10) elektrisch in Kontakt mit dem ersten Stromkreis des ersten Trägers (10) getragen zu werden, sowie eine zweite Seite (31b, 36b, 41b, 46b), die dazu ausgelegt ist, elektrisch mit einem weiteren Stromkreis mit einer Wärmekontaktfläche verbunden zu werden, die geringer als die zwischen der ersten Seite (31a, 36a, 41a, 46a) und dem ersten Träger (10) ist,
wobei jedes zweite Bauteil (32, 37, 42, 47) eine erste Seite (32a, 37a, 42a, 47a) aufweist, die dazu ausgelegt ist, am zweiten Träger (20) elektrisch in Kontakt mit dem zweiten Stromkreis des zweiten Trägers (20) getragen zu werden, sowie eine zweite Seite (32b, 37b, 42b, 47b), die dazu ausgelegt ist, elektrisch mit einem weiteren Stromkreis mit einer Wärmekontaktfläche verbunden zu werden, die geringer als die zwischen der ersten Seite (32a, 37a, 42a, 47a) und dem zweiten Träger (20) ist,
wobei das Modul (1) **dadurch gekennzeichnet ist, dass** jedes erste Bauteil (31, 36, 41, 46) eines Paares (30, 35, 40, 45) mittels seiner ersten Seite (31a, 36a, 41a, 46a) über den ersten Träger (10) elektrisch in Kontakt mit dem ersten Stromkreis getragen wird und über seine zweite Seite (31b, 36b, 41b, 46b) mit dem zweiten Stromkreis verbunden ist,
und dass jedes zweite Bauteil (32, 37, 42, 47) eines Paares (30, 35, 40, 45) mittels seiner ersten Seite (32a, 37a, 42a, 47a) über den zweiten Träger (20) elektrisch in Kontakt mit dem zweiten Stromkreis getragen wird und über seine zweite Seite (32b, 37b, 42b, 47b) mit dem ersten Stromkreis so verbunden ist, dass es eine dem ersten Bauteil (31, 36, 41, 46) des ersten Paares (30, 35, 40, 45) äquivalente Anordnung aufweist, indem es bei identischen Bedingungen parallel zum ersten Bauteil (31, 36, 41, 46) betrieben wird.

2. Modul (1) nach Anspruch 1, wobei jedes der Bauteile (31, 32, 36, 37, 41, 42, 46, 47) mit dem Stromkreis des anderen Trägers (10, 20) als derjenige verbunden ist, der diese trägt, und zwar mittels Schweißbrücken, wie sie beispielweise durch Kugelschweißen oder -löten erhalten werden.

3. Modul (1) nach Anspruch 1 oder 2, wobei die erste Seite (31a, 32a, 36a, 37a, 41a, 42a, 36a, 37a) eines jeden der Bauteile (31, 32, 36, 37, 41, 42, 46, 47) über das Schweiß- bzw. Lötmaterial an den diese tragenden Träger (10, 20) befestigt ist.

4. Modul (1) nach einem der Ansprüche 1 bis 3, wobei die Bauteile (31, 32, 41, 42) zumindest eines Paares (30, 40) jeweils zumindest einen Steuerkontakt (31G, 32G, 41G, 42G) und zumindest zwei Leistungskontakte (31C, 31E, 31C, 32E, 41C, 41E, 42C, 42E) enthalten, wobei der Steuerkontant (31G, 32G, 41G, 42G) auf der zweiten Seite (31b, 32b, 41b, 42b) angeordnet ist und zumindest ein erster Leistungskontakt (31C, 32C, 41C, 42C) auf der ersten Seite (31a, 32a, 41a, 42a) angeordnet ist, wobei der Stromkreis eines jeden aus erstem und zweitem Träger (10, 20) zumindest eine erste Hochleistungs-Leiterbahn (11, 12, 13, 14, 21, 22, 23, 24), Leistungsbahn genannt, und eine Steuer-Leiterbahn (15, 16, 25, 26), Steuerbahn genannt, enthält,
und wobei die Bauteile (31, 32, 41, 42) des zumindest einen Paares (30, 40) an dem entsprechenden Träger (10, 20) mit dem Leistungskontakt (31C, 32C, 41,C, 42C) der ersten Seite (31a, 32a, 41a, 42a) in Kontakt an einer Hochleistungsbahn (11, 21, 14, 24) und mit dem Steuerkontakt (31G, 32G, 41G, 42G) angeordnet sind, der mit einer Steuerbahn (25, 15, 26, 16) des anderen Trägers (20, 10) als mit demjenigen verbunden ist, an dem das Bauteil (31, 32, 41, 42) getragen ist.

5. Modul (1) nach Anspruch 4, wobei die Steuerbahn (15, 16) des ersten Trägers (10) einen Bahnabschnitt aufweist, der der ersten Leistungsbahn (21, 23) des zweiten Trägers (20) gegenüberliegt, und wobei die Steuerbahn (25, 26) des zweiten Trägers (20) einen Bahnabschnitt aufweist, welcher der ersten Leistungsbahn (11, 13) des ersten Trägers (10) gegenüberliegt.

6. Modul (1) nach Anspruch 5, wobei der zweite Leistungskontakt (31E, 32E, 41E, 42E) eines jeden der Bauteile (31, 32, 41, 42), der einen Steuerkontakt (31G, 32G, 41G, 42G) enthält, auf der zweiten Seite (31a, 32a, 41a, 42a) des Bauteils (31, 32, 41, 42) angeordnet ist, wobei der erste und der zweite Träger (10, 20) jeweils zumindest eine zweite Leistungsbahn (12, 14, 22, 24) enthalten, wobei die Bauteile (31, 32, 41, 42), die einen Steuerkontakt (31G, 32G, 41G, 42G) enthalten, jeweils mit ihrem zweiten Steuerkontakt (31E, 32E, 41E, 42E) mit der zweiten Leistungsbahn (12, 14, 22, 24) des anderen Trägers (20, 10) als desjenigen verbunden sind, an dem das Bauteil (31, 32, 41, 42) getragen ist.

7. Elektronisches Modul nach Anspruch 6, wobei die zweite Leistungsbahn (12, 14) des ersten Trägers (10) einen Bahnabschnitt enthält, der der ersten Leistungsbahn (21, 23) des zweiten Trägers (20) gegenüberliegt, wobei die zweite Leistungsbahn (22, 24) des zweiten Trägers (20) einen Bahnabschnitt enthält, welcher der ersten Leistungsbahn (11, 13) des ersten Trägers (10) gegenüberliegt.

8. Verfahren zum Herstellen eines elektronischen Leistungsmoduls (1), umfassend die nachfolgenden Schritte:
- Bereitstellen eines ersten und eines zweiten Trägers (10, 20), die jeweils einen ersten bzw. einen zweiten Stromkreis enthalten,
- Bereitstellen einer Mehrzahl von elektronischen Leistungsbauteilen (31, 32, 36, 37, 41, 42, 46, 47), wobei jedes Bauteil (31, 32, 36, 37, 41, 42, 46, 47) eine erste Seite (31a, 32a, 36a, 37a, 41a, 42a, 36a, 37a) aufweist, die dazu bestimmt ist, von einem Träger (10, 20) elektrisch in Kontakt mit einem Stromkreis des Trägers (10, 20) getragen zu werden, sowie eine zweite Seite (31b, 32b, 36b, 37b, 41b, 42b, 46b, 47b), die dazu bestimmt ist, elektrisch mit einem weiteren Stromkreis mit einer Wärmekontaktfläche verbunden zu werden, die geringer als die zwischen der ersten Seite (31a, 32a, 36a, 37a, 41a, 42a, 36a, 37a) und dem ersten Träger (10) ist, wobei die Bauteile (31, 32, 36, 37, 41, 42, 46, 47) dazu bestimmt sind, in Paaren (30, 35, 40, 45) angeordnet zu werden, die jeweils ein erstes Bauteil (31, 36, 42, 47) und ein zweites Bauteil (32, 37, 42, 47) aufweisen, die im Wesentlichen identisch sind,
- Anbringen eines jeden ersten Bauteils (31, 36, 41, 46) an den ersten Träger (10) so, dass es mit seiner ersten Seite (31a, 36a, 41a, 46a) von dem ersten Träger (10) elektrisch in Kontakt mit dem ersten Stromkreis getragen wird,
- Anbringen eines jeden zweiten Bauteils (32, 37, 42, 47) an den zweiten Träger (20) so, dass es mit seiner ersten Seite (32a, 37a, 42a, 47a) von dem zweiten Träger (20) elektrisch in Kontakt mit dem zweiten Stromkreis getragen wird,
- Zusammenfügen des ersten und des zweiten Trägers (10, 20), indem die zweite Seite (31b, 36b, 41b, 46b) eines jeden ersten Bauteils (31, 36, 41, 46) mit dem zweiten Stromkreis des zweiten Trägers (20) elektrisch verbunden wird und die zweite Seite (32b, 37b, 42b, 47b) eines jeden zweiten Bauteils (32, 37, 42, 47) mit dem ersten Stromkreis des ersten Trägers (10) elektrisch so verbunden wird, dass es parallel mit dem entsprechenden ersten Bauteil (31, 36, 41, 46) betrieben wird.

9. Herstellungsverfahren nach Anspruch 8, wobei die Schritte des Anbringens eines jeden ersten Bauteils (31, 36, 41, 46) und eines jeden zweiten Bauteils (32, 37, 42, 47) an den ersten bzw. zweiten Träger (10, 20) ein Schritt des Lötens bzw. Schweißens eines jeden aus ersten Bauteilen (31, 36, 41, 46) und zweiten Bauteilen (32, 37, 42, 47) sind.

10. Herstellungsverfahren nach Anspruch 9, wobei bei dem Schritt des Zusammenfügens von erstem und zweitem Träger (10, 20) ein Unterschritt des Einsetzens von Schweißkugeln (19) und ein Unterschritt des Erhitzens vorgesehen sind, um eine Kugelschweißung mit den Schweißkugeln (19) zu erhalten.

## Claims

1. Power electronic module (1) comprising:
- a plurality of power electronic components (31, 32, 36, 37, 41, 42, 46, 47),
- a first and a second support (10, 20) arranged approximately parallel to each other and that comprise a first and a second electrical circuit respectively,
wherein the components (31, 32, 36, 37, 41, 42, 46, 47) are arranged in pairs (30, 35, 40, 45) comprising each one a first component (31, 36, 41, 46) and a second component (32, 37, 42, 47) approximately identical,
wherein each first component (31, 36, 41, 46) comprises a first face (31a, 36a, 41a, 36a) adapted for be being supported on the first support (10) in electrical contact with an the first electrical circuit of the first support (10) and a second face (31b, 36b, 41b, 46b) adapted for be being electrically connected to an other electrical circuit with a smaller thermal contact area than the contact area between the first face (31a, 36a, 41a, 36a) and the first support (10),
wherein each second component (32, 37, 42, 47) comprises a first face (32a, 37a, 42a, 37a) adapted for be being supported on the second support (20) in electrical contact with an the second electrical circuit of the second support (10) and a second face (31b, 36b, 41b, 42b, 46b) adapted for be being electrically connected to the second another electrical circuit with a smaller thermal contact area than the contact area between the first face (31a, 36a, 41a, 36a) and the first support (10),
the module **being characterised in that** each first component (31, 36, 41, 46) of a pair (30, 35, 40, 45) is supported by the means of its first face (31a, 36a, 41a, 36a) by the first support (10) in electrical contact with the first electrical circuit, and is connected by its second face (31b, 36b, 41b, 46b) to the second electrical circuit,
and **in that that** each second component (32, 37, 42, 47) of a pair (30, 35, 40, 45) is supported by the means of its first face (32a, 37a, 42a, 37a) by the second support (10) in electrical contact with the second electrical circuit, and is connected by its first face (32b, 37b, 42b, 47b) to the first electrical circuit in order to have an arrangement equivalent to the first component (31, 36, 41, 46) of said pair (30, 35, 40, 45) by operating in parallel with the first component (31, 36, 41, 46) in identical condition.

2. Module (1) according to claim 1, in which each component (31, 32, 36, 37, 41, 42, 46, 47) is connected to the electrical circuit of the support (10, 20) that is not supporting it by means of solder bridges for example such as can be obtained by ball soldering or brazing.

3. Module (1) according to claim 1 or 2, in which the first face (31a, 32a, 36a, 37a, 41a, 42a, 36a, 37a) of each component (31, 32, 36, 37, 41, 42, 46, 47) is fixed to the support (10, 20) supporting it by solder or brazing material.

4. Module (1) according to any one of claims 1 to 3, in which each component (31, 32, 41, 42) of at least one pair (30, 40) comprises at least one control contact (31G, 32G, 41G, 42G) and at least two power contacts (31C, 31E, 31C, 32E, 41C, 41E, 42C, 42E), the control contact (31G, 32G, 41G, 42G) being located on the second face (31b, 32b, 41b, 42b) and at least one first power contact (31C, 32C, 41C,42C) being located on the first face (31a, 32a, 41a, 42a), the electrical circuit of each of the first and the second supports (10, 20) including at least one first high power circuit conducting track (11, 12, 13, 14, 21, 22, 23, 24), called the power track, and a control conducting track (15, 16, 25, 26), called the control track,
and in which the components (31, 32, 41, 42) of the at least one pair (30, 40) are arranged on the corresponding support (10, 20) with the power contact (31C, 32C, 41C, 42C) of the first face (31a, 32a, 41a, 42a) in contact with a high power track (11, 21, 14, 24) and with the control contact (31G, 32G, 41G, 42G) connected to a control track (25, 15, 26, 16) of the support (20,10) on which the component is not supported (31, 32, 41, 42).

5. Module (1) according to claim 4, in which the control track (15, 16) of the first support (10) has a track portion facing the first power track (21, 23) of the second support (20) and in which the control track (25, 26) of the second support (20) has a track portion facing the first power track (11, 13) of the first support (10).

6. Module (1) according to claim 5, in which the second power contact (31E, 32E, 41E, 42E) of each of the components (31, 32, 41, 42) which comprises a control contact (31G, 32G, 41G, 42G) is arranged on the second face (31a, 32a, 41a, 42a) of the component (31, 32, 41, 42), each of the first and second supports (10, 20) comprising at least one second power track (12, 14, 22, 24), the components (31, 32, 41, 42) which comprises a control contact (31G, 32G, 41G, 42G), having each the second control contact (31E, 32E, 41E, 42E) connected to the second power track (12, 14, 22, 24) of the support (20,10) on which the component (31, 32, 41, 42) is not supported.

7. Electronic module according to claim 6, in which the second power track (12, 14) of the first support (10) comprises a track portion facing the first power track (21, 23) of the second support (20), the second power track (22, 24) of the second support (20) comprising a track portion facing the first power track (11, 13) of the first support (10).

8. Method of manufacturing an electronic power module (1) comprising the following steps:
- supply a first and a second support (10, 20) comprising a first and a second electrical circuit respectively,
- supply a plurality of power electronic components (31, 32, 36, 37, 41, 42, 46, 47), each component (31, 32, 36, 37, 41, 42, 46, 47) comprising a first and a second face (31a, 32a, 36a, 37a, 41a, 42a, 46a, 47a, 31b, 32b, 36b, 37b, 41b, 42b, 46b, 47b), the components (31, 32, 36, 37, 41, 42, 46, 47) being designed to be arranged in pairs (30, 35, 40, 45) each comprising a first component (31, 36, 41, 46) and a second component (32, 37, 42, 47) approximately identical,
- installation of each first component (31, 36, 41, 46) on the first support (10) such that its first face (31a, 36a, 41a, 46a) supported by the first support (10) is in electrical contact with the first electrical circuit,
- install each second component (32, 37, 42, 47) on the second support (20) such that its first face (32a, 37a, 42a, 47a) supported by the second support (20) is in electrical contact with the second electrical circuit,
- assemble the first and the second support (10, 20) by electrically connecting the second face (31b, 36b, 41b, 46b) of each first component (31, 36, 41, 46) to the second electrical circuit of the second support (20) and electrically connecting the second face (32b, 37b, 42b, 47b) of each second component (32, 37, 42, 47) to the first electrical circuit of the first support (10) so as to operate in parallel with the corresponding first component (31, 36, 41, 46).

9. Manufacturing method according to claim 8, in which the assembly steps of each first component (31, 36, 41, 46) and each second component (32, 37, 42, 47) on the first and second supports (10, 20) respectively is a step to solder or braze each of said first component (31, 36, 41, 46) and second component (32, 37, 42, 47).

10. Manufacturing method according to claim 9, in which during the assembly step of the first and the second support (10, 20), there is a sub-step to install solder balls (19) and a heating sub-step for ball soldering with said soldering balls (19).
